# EUROPÄISCHE PATENTSCHRIFT

(11) **EP 2 299 793 B1**
(45) Veröffentlichungstag und Bekanntmachung des Hinweises auf die Patenterteilung: **09.11.2011**
(21) Anmeldenummer: 09011910.8
(22) Anmeldetag: 18.09.2009
(51) Int. Cl.: H05K 7/20, H01R 9/22, H02M 7/00

(54) **Wechselrichter mit einem Gehäuse**
Inverter with a casing
Convertisseur doté d'un boîtier

(43) Veröffentlichungstag der Anmeldung: 23.03.2011
(73) Patentinhaber: SMA Solar Technology AG, 34266 Niestetal (DE)
(72) Erfinder: Donth, Andreas, 34295 Besse (DE); Hobein, Thorsten, 34233 Fuldatal (DE); Gebert, Bernd, 34266 Niestetal (DE)
(74) Vertreter: Walther, Walther & Hinz GbR

(56) Entgegenhaltungen:
- EP-A1- 1 657 797
- EP-A1- 1 995 861

## Beschreibung

Die vorliegende Erfindung betrifft einen Wechselrichter mit einem Gehäuse, wobei das Gehäuse einen vom Gehäuse abziehbaren Griffstecker aufweist, der in im Gehäuse des Wechselrichters eingestecktem Zustand in elektrischer Verbindung mit dem Wechselrichter steht, siehe z. B. EP 1 657 797 A1.

Wechselrichter sind aus dem Stand der Technik hinreichend bekannt. Solche Wechselrichter haben üblicherweise ein Gehäuse, das mit der Rückwand an der Wandung eines Gebäudes oder eines anderen Bauwerkes anliegt. Im Inneren des Gehäuses des Wechselrichters wird durch die dort angeordneten elektrischen und elektronischen Bauteile, z. B. Spulen, Wärme erzeugt, die abgeführt werden muss. Insofern sind im Gehäuse des Wechselrichters Lüfter vorgesehen, die für eine Kühlung der im Gehäuse angeordneten Bauteile sorgen. Darüber hinaus ist allerdings auch die Rückwand eines solchen Wechselrichters häufig mit Kühlrippen versehen, um auch über die Rückwand eine Wärmeabfuhr zu ermöglichen. Die Wärmeabfuhr erfolgt hierbei im Wesentlichen durch die an der Rückwand des Wechselrichtergehäuses entlangströmende Umgebungsluft.

Es ist nun allerdings bekannt, auch an der Rückwand des Gehäuses Lüfter anzuordnen, die diese Luftzirkulation unterstützen und insofern für eine verbesserte Kühlung im Bereich der Rückwand des Wechselrichters sorgen. Diese Lüfter benötigen eine Stromversorgung, weshalb es immer notwendig ist, dass der Lüfter mittels eines Steckers aus dem Inneren des Wechselrichtergehäuses mit Strom versorgt wird. Ein solcher Durchtritt in das Innere des Gehäuses des Wechselrichters stellt immer eine potenzielle Gefahrenquelle für eintretende Feuchtigkeit dar.

Darüber hinaus können solche Lüfter verschmutzen, wobei ein Austausch bzw. eine Säuberung des Lüfters nur dann möglich ist, wenn der Wechselrichter insgesamt beispielsweise von der Gebäudewand abgenommen worden ist, da nur dann die Möglichkeit des Zugangs zu dem auf der Rückwand des Gehäuses angeordneten Lüfter besteht.

Zusammenfassend ist demzufolge festzuhalten, dass bei verschiedenen Anwendungsfällen im Bereich der Rückwand außen angeordnete Lüfter notwendig sind, um für eine ausreichende Kühlung des Wechselrichters zu sorgen, dass allerdings der Zugang zu dem Lüfter aufgrund der Anbringung an oder im Bereich der Rückwand des Gehäuses erschwert ist, wenn der Lüfter gereinigt werden muss.

Nachteilig ist weiterhin, dass zur Stromversorgung des Lüfters zumindest ein Durchgang in das Innere des Wechselrichters erforderlich ist, wodurch naturgemäß die Gefahr des Eintritts von Feuchtigkeit in das Gehäuseinnere des Wechselrichters erhöht ist.

Die der Erfindung zugrunde liegende Aufgabe besteht demzufolge darin, einen Wechselrichter der eingangs genannten Art bereitzustellen, bei dem zum einen der Austausch des Lüfters wesentlich erleichtert ist, und darüber hinaus für die Stromversorgung des Lüfters kein gesonderter Durchtritt in das Innere des Gehäuses erforderlich ist.

Zur Lösung der Aufgabe wird erfindungsgemäß vorgeschlagen, dass der Griffstecker einen Lüfter zur Kühlung des Gehäuses des Wechselrichters aufweist, wobei die Stromversorgung des Lüfters durch den Griffstrecker erfolgt. Der Griffstecker ragt hierbei bis in den Bereich der Rückwand des Wechselrichters, sodass der durch den Lüfter erzeugte Luftstrom an der Rückwand entlang strömt.

Dadurch, dass der Griffstecker in im Gehäuse des Wechselrichters eingestecktem Zustand mit Strom vom Wechselrichter versorgt wird, also in elektrischer Verbindung mit dem Wechselrichter steht, ist eine gesonderte Stromversorgung des Lüfters nicht erforderlich.

Nach einem besonders vorteilhaften Merkmal der Erfindung ist der Griffstecker als Lasttrenner ausgebildet.

Aus der DE 102 25 259 B3 ist ein als Steckverbinder ausgebildeter Lasttrenner bekannt. Durch den aus dieser Literaturstelle bekannten Lasttrenner wird die Entstehung eines Lichtbogens vermieden bzw. zumindest reduziert, wenn der Wechselrichter von beispielsweise einer PV-Anlage getrennt wird. Insofern steht ein als Griffstecker ausgebildeter Lasttrenner in elektrischer Verbindung mit dem Wechselrichter. Das bedeutet, dass durch den Griffstecker die Stromversorgung für den Lüfter erfolgen kann. Das bedeutet aber auch, dass durch Ziehen des Griffsteckers, also beispielsweise zur Trennung des Wechselrichters von der PV-Anlage, der Wechselrichter zumindest DC-seitig stromlos wird. Hierbei wird dann der Lüfter zugänglich, sodass dieser gereinigt oder auch ausgetauscht werden kann. Insbesondere ist keine gesonderte Stromversorgung erforderlich, die einem Durchgang in das Innere des Gehäuses des Wechselrichters erforderlich macht.

Weitere vorteilhafte Merkmale ergeben sich aus den Unteransprüchen.

So ist insbesondere vorgesehen, dass der Griffstecker ein Lüftergehäuse zur einschiebbaren Aufnahme des Lüfters aufweist, wobei vorteilhaft auch das Lüftergehäuse lösbar durch den Griffstecker aufnehmbar ist. Durch einen solchen modularen Aufbau vereinfacht sich die Montage.

Nach einem besonders vorteilhaften Merkmal ist vorgesehen, dass die Rückwand des Wechselrichters einen kaminartigen Abschnitt aufweist, der sich über die Länge des Gehäuses erstreckt, wobei sich der Lüfter im Bereich des kaminartigen Abschnitts im eingesteckten Zustand des Griffsteckers befindet. Der kaminartige Abschnitt bildet in Verbindung mit beispielsweise der Wand des Gebäudes, an dem sich der Wechselrichter befindet, den kaminartigen Abschnitt, wobei insbesondere in diesem kaminartigen Abschnitt Kühlrippen angeordnet sind, die sich dann in dem durch den Lüfter erzeugten Luftstrom befinden.

Anhand der Zeichnungen wird die Erfindung nachstehend beispielhaft näher erläutert.
- Figur 1: zeigt eine Ansicht auf die Rückwand des Wechselrichtergehäuses bei eingestecktem Griffstecker;

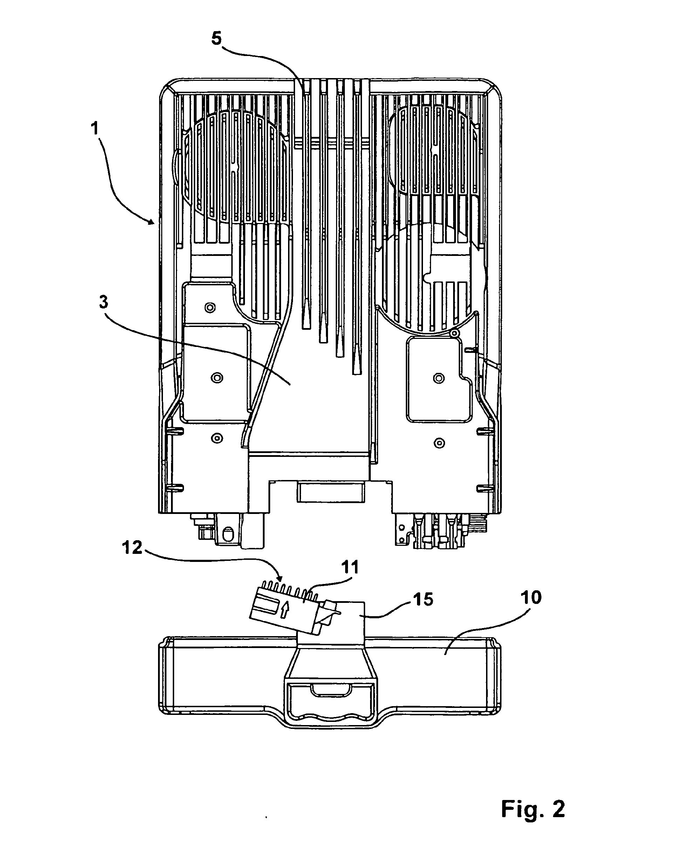

- Figur 2: zeigt eine Darstellung gemäß Figur 1 bei gezogenem Griffstecker;
- Figur 3: zeigt den Griffstecker in perspektivischer Darstellung, wobei das Lüftergehäuse, einschließlich des Lüfters, von dem Griffstecker getrennt dargestellt ist.

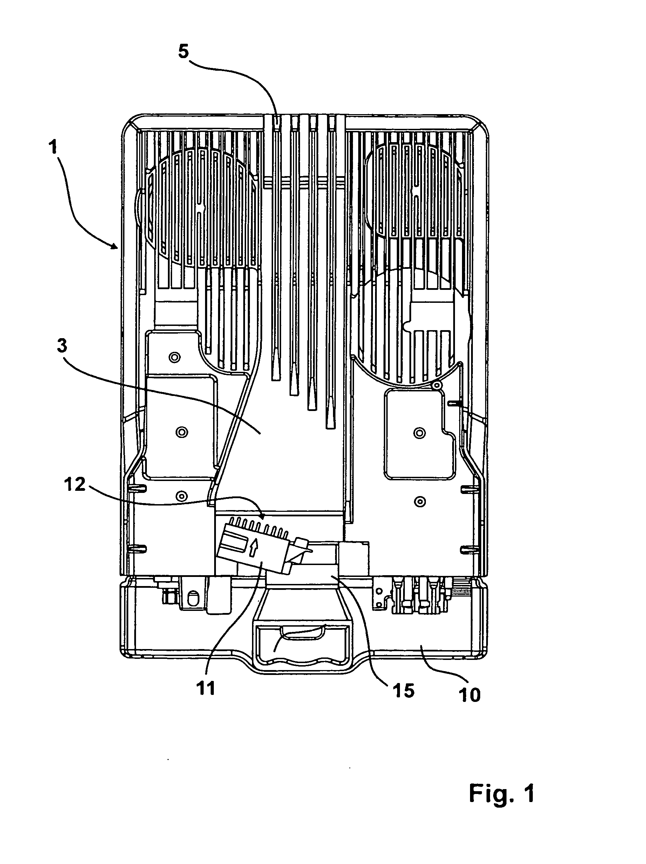

Gemäß Figur 1 ist das Gehäuse des Wechselrichters mit 1 bezeichnet. Das Wechselrichtergehäuse 1 zeigt auf seiner Unterseite den mit 10 bezeichneten Griffstecker. Der Griffstecker besitzt das Lüftergehäuse 11 mit dem darin befindlichen Lüfter 12. Der Lüfter 12 ist in dem Gehäuse 11 derart ausgerichtet, dass dieser die von unten angesaugte Frischluft in den kaminartigen Abschnitt 3 in der Rückwand 2 des Gehäuses 1 fördert. Der kaminartige Abschnitt 3 stellt sich als ein Abschnitt dar, der in Richtung auf das Innere des Wechselrichtergehäuses vertieft ausgebildet ist, also im Querschnitt etwa U-förmig ausgebildet ist. Im Bereich dieses kaminartigen Abschnitts befinden sich Kühlrippen 5, die für eine Wärmeabfuhr der im Inneren des Gehäuses entstehenden Wärme sorgen.

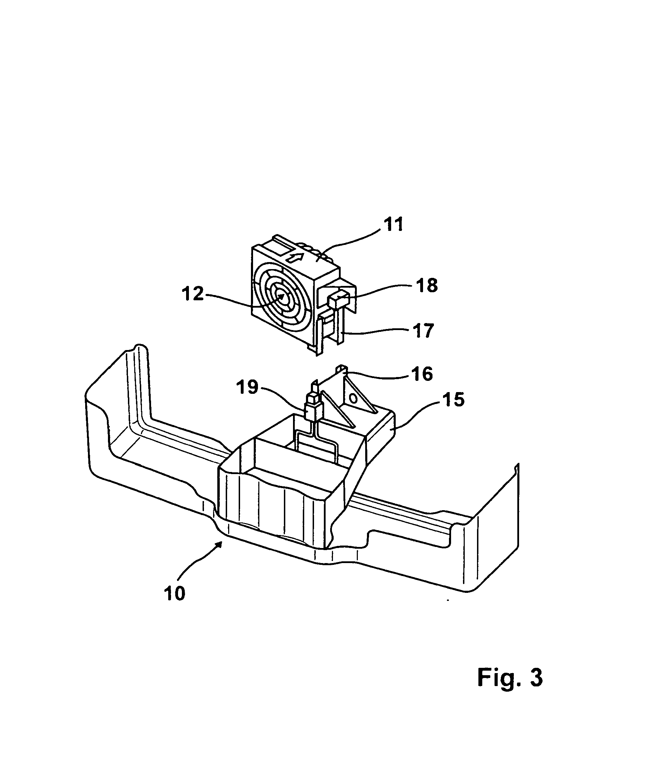

Betrachtet man nunmehr Figur 3, so ist das Lüftergehäuse 11 mit dem darin einsitzenden Lüfter 12 erkennbar. Der Lüfter 12 wird hierbei einclipsbar von dem Lüftergehäuse aufgenommen. Der Griffstecker 10 besitzt eine Konsole 15, auf der eine Führung 16 vorgesehen ist, die der einsteckbaren Aufnahme des Lüftergehäuses 11 dient, wie sich dies unmittelbar in Anschauung von Figur 3 ergibt. Erkennbar ist ebenfalls, dass im Bereich der Schiene 16 und des Schlittens 17 am Lüftergehäuse sich der Stecker 18 für die Stromversorgung des Lüfters befindet, der mit dem Stecker 19 an der Konsole 15 des Griffsteckers 10 verbunden wird. Der Griffstecker ist Teil des Gehäuseunterteils des Wechselrichters und wird nach unten vom Gehäuse des Wechselrichters abgezogen.

## Patentansprüche

1. Wechselrichter mit einem Gehäuse (1), wobei das Gehäuse (1) einen vom Gehäuse (1) abziehbaren Griffstecker (10) aufweist, der in im Gehäuse des Wechselrichters eingestecktem Zustand in elektrischer Verbindung mit dem Wechselrichter steht,
**dadurch gekennzeichnet,**
**dass** der Griffstecker (10) einen Lüfter (12) zur Kühlung der Rückwand (2) des Gehäuses (1) des Wechselrichters aufweist, wobei die Stromversorgung des Lüfters (12) durch den Griffstecker (10) erfolgt.

2. Wechselrichter mit einem Gehäuse (1) nach Anspruch 1,
**dadurch gekennzeichnet,**
**dass** der Griffstecker (10) als Lasttrenner ausgebildet ist.

3. Wechselrichter mit einem Gehäuse (1) nach einem der voranstehenden Ansprüche,
**dadurch gekennzeichnet,**
**dass** der Griffstecker (10) ein Lüftergehäuse (11) zur einschiebbaren Aufnahme des Lüfters (12) aufweist.

4. Wechselrichter mit einem Gehäuse (1) nach Anspruch 3,
**dadurch gekennzeichnet,**
**dass** das Lüftergehäuse (11) lösbar durch den Griffstecker (10) aufnehmbar ist.

5. Wechselrichter mit einem Gehäuse (1) nach einem der voranstehenden Ansprüche,
**dadurch gekennzeichnet,**
**dass** die Rückwand (1) einen kaminartigen Abschnitt (3) aufweist, der sich über die Länge des Gehäuses (1) erstreckt, wobei sich der Lüfter (12) des Gehäuses (1) im Bereich des kaminartigen Abschnitts (3) im eingesteckten Zustand des Griffsteckers (10) befindet.

## Claims

1. Inverter with a housing (1), wherein the housing (1) comprises a grip plug (10) which is withdrawable from the housing (1) and which in the state of being plugged into the housing of the inverter is in electrical connection with the inverter, **characterised in that** the grip plug (10) comprises a fan (12) for cooling the rear wall (2) of the housing (1) of the inverter, wherein the power supply of the fan (12) is realized by the grip plug (10).

2. Inverter with a housing (1) according to claim 1, **characterised in that** the grip plug (10) is constructed as a load-break switch.

3. inverter with a housing (1) according to one of the preceding claims, **characterised in that** the grip plug (10) comprises a fan housing (11) for insertable reception of the fan (12).

4. Inverter with a housing (1) according to claim 3, **characterised in that** the fan housing (11) is detachably receivable by the grip plug (10).

5. Inverter with a housing (1) according to any one of the preceding claims, **characterised in that** the rear wall (1) has a chimney-like section (3) which extends over the length of the housing (1), wherein the fan (12) of the housing (1) in the plugged-in state of the grip plug (10) is disposed in the region of the chimney-like section (3).

## Revendications

1. Onduleur comportant un boîtier (1), dans lequel le boîtier (1) comporte une fiche à poignée (10) qui peut être débranchée du boîtier (1) et qui, à l'état branché dans le boîtier de l'onduleur, est en connexion électrique avec l'onduleur,
**caractérisé en ce que**
la fiche à poignée (10) comporte un ventilateur (12) pour le refroidissement de la paroi arrière (2) du boîtier (1) de l'onduleur, l'alimentation électrique du ventilateur (12) étant réalisée par la fiche à poignée (10).

2. Onduleur comportant un boîtier (1) seion la revendication i,
**caractérisé en ce que**
la fiche à poignée (10) constitue un sectionneur à coupure en charge.

3. Onduleur comportant un boîtier (1) selon l'une des revendications précédentes,
**caractérisé en ce que**
la fiche à poignée (10) comporte un boîtier de ventilateur (11) agencé pour recevoir le ventilateur (12) par emmanchement.

4. Onduleur comportant un boîtier (1) selon la revendication 3,
**caractérisé en ce que**
le boîtier de ventilateur (11) peut être reçu par la fiche à poignée (10) de façon amovible.

5. Onduleur comportant un boîtier (1) selon l'une des revendications précédentes,
**caractérisé en ce que**
la paroi arrière (1) comporte un segment (3) en forme de cheminée qui s'étend sur la longueur du boîtier (1), le ventilateur (12) du boîtier (1) se trouvant dans la région du segment en forme de cheminée (3) à l'état branché de la fiche à poignée (10).
